# EUROPÄISCHE PATENTSCHRIFT

(11) **EP 2 095 238 B1**
(45) Veröffentlichungstag und Bekanntmachung des Hinweises auf die Patenterteilung: **05.05.2010**
(21) Anmeldenummer: 07856039.8
(22) Anmeldetag: 28.11.2007
(51) Int. Cl.: G06F 11/36

(54) **VERFAHREN ZUM TESTEN EINES COMPUTERPROGRAMMS**
METHOD FOR TESTING A COMPUTER PROGRAMME
PROCEDE DE TEST D'UN PROGRAMME D'ORDINATEUR

(30) Priorität: 28.11.2006 DE 102006056432
(43) Veröffentlichungstag der Anmeldung: 02.09.2009
(73) Patentinhaber: Certess, Inc., Campbell CA 95008 (US)
(72) Erfinder: HAMPTON, Mark, 38260 La Cote St Andre (FR); GROSSE, Jörg, Santa Cruz, CA 95062 (US)
(74) Vertreter: Carlsohn, Alexander
(86) Internationale Anmeldenummer: PCT/DE2007/002146
(87) Internationale Veröffentlichungsnummer: WO 2008/064658

(56) Entgegenhaltungen:
- FR-A- 2 873 832
- US-A- 3 711 863
- US-A- 5 694 540
- VADO P ET AL: "A methodology for validating digital circuits with mutation testing" CIRCUITS AND SYSTEMS, 2000. PROCEEDINGS. ISCAS 2000 GENEVA. THE 2000 I EEE INTERNATIONAL SYMPOSIUM ON MAY 28-31, 2000, PISCATAWAY, NJ, USA,IEEE, Bd. 1, 1. Mai 2000 (2000-05-01), Seiten I_343-I_346, XP010503205 ISBN: 978-0-7803-5482-1

## Beschreibung

Die Erfindung betrifft ein Verfahren zum Testen eines Computerprogramms nach der Änderung einer ersten Version des Computerprogramms in eine zweite Version des Computerprogramms aufgrund einer Revision des Computerprogramms.

Nach dem Stand der Technik ist die Entwicklung eines Computerprogramms mit einem zeitaufwendigen Testverfahren verbunden, um Fehler in dem Computerprogramm zu erkennen. Nur in seltenen Fällen werden Computerprogramme vollständig neu geschrieben. In der Regel wird die letzte Version des Computerprogramms angepaßt, um neue Funktionen zu implementieren oder nach Problemen zu korrigieren. Eine solche neue Version des Computerprogramms erfordert eine vollständige Testung der Software. Allerdings sind Verfahren zum selektiven Testen neuer Versionen des Computerprogramms entwickelt worden, die eine Verringerung des Testaufwandes ermöglichen sollen.

US 5,673,387 beschreibt ein Verfahren zum selektiven Regressionstesten eines Computerprogramms. Das Verfahren umfaßt die Bestimmung der Tests einer Testsuite, die nach einer Änderung des Programms erneut ausgeführt werden müssen. Dazu werden die Einheiten der Software bestimmt, die verändert wurden, und Änderungsinformationen und Coverageinformationen analysiert, um die Tests zu bestimmten, die die veränderten Einheiten abdecken. Es gibt jedoch keinen Nachweis, daß die ausgewählten Tests in der Lage sind, Fehler finden zu können, die infolge einer Revision des Computerprogramms eingebaut worden sind. Außerdem kann die Anzahl der ausgewählten Tests sehr hoch sein und unnötige Tests umfassen.

US 5,778,169 offenbart ein Verfahren zum Testen eines Computerprogramms, das nur minimale Coverageinformationen erzeugen soll. Dabei ist das Einbauen eines ersten Coverage-Punktes in ein erstes Statement einer ersten Version eines Computerprogramms und das Testen der ersten Version mittels einer Vielzahl von Tests vorgesehen. Anschließend wird unter Verwendung der Testergebnisse eine Teilmenge der Vielzahl von Tests bestimmt, die den ersten Coverage-Punkt ansprachen. Nach einer Veränderung der ersten Version in eine zweite Version des Computerprogramms wird die zweite Version unter Verwendung der Teilmenge der Tests getestet. US 5,778,169 nutzt zur Auswahl der Tests die Aktivierungsinformationen aller Tests und wählt die Tests aus, die ein bestimmtes Statement angesprochen haben. Dazu sind manuelle Eingriffe des Programmierers erforderlich.

Der Stand der Technik basiert somit auf der Nutzung von Codecoverage-Ergebnissen, die aus der Testung der ersten Version des Computerprogramms gewonnen werden. Coverage bedeutet hierbei, daß spezielle Statements ausgeführt worden sind, während das Programm ausgeführt wird. Nachteil dieser Verfahren ist jedoch, daß Tests ausgeführt werden, die möglicherweise keinerlei Einfluß auf Änderungen des Quellcodes haben. Mit anderen Worten, es gibt keinen Beweis, daß die Tests, die auf Basis der Coverage-Ergebnisse ausgewählt werden, Merkmale testen, die sich auf die Codeänderung beziehen. Aus diesem Grund ist der Einsatz solcher Verfahren in modernen Testumgebungen, die beschränkte zufällige Tests ("constrained random tests") verwenden, nicht oder kaum nützlich. Dies betrifft insbesondere die Validierung von Schaltkreisen.

FR 2 873 832 A1 offenbart ein Verfahren zur Bewertung von Computerprogrammtests mittels einer Mutationsanalyse. Das Verfahren umfasst die Ausführung eines mutierten Programms durch die Einführung von Mutationen in ein Computerprogramm und die Identifizierung von mutierten Programmen, die mit Hilfe eines vorbestimmten Tests ein Ergebnis hervorbringen, das mit einem vorgegebenen Ergebnis identisch ist. Das Verfahren sieht die Auswahl einer Gruppe von Test aus einer Vielzahl von Tests vor, die für jede Mutation relevant sind. Unter Anwendung eines speziellen Kriteriums auf die ausgewählten Tests wird eine Klassifizierung vorgenommen. Anschließend werden die mutierten Programme in der Reihenfolge der Klassifizierung ausgeführt, wobei jedes mutierte Programm mit den Tests der ausgewählten Gruppe von Tests ausgeführt wird.

Vado, P., et al. offenbaren in "A methodology for validating digital circuits with mutation testing" Circuits and Systems, 2000. Proceedings. ISCAS 2000 Geneva. The 2000 IEEE International Symposium on May 28-31, 2000, Piscata-Way, NJ, USA, IEEE, Bd. 1, 1. Mai 2000, Seiten I_343-I_346, ein Verfahren zur Mutation von Spezifikationen integrierter Schaltkreis, ohne die Mutationsanalyse selbst zu beschreiben.

Aufgabe der Erfindung ist es, die Nachteile nach dem Stand der Technik zu beseitigen. Es soll insbesondere ein Verfahren angegeben werden, das eine schnelle und effektivere Testung einer veränderten Version eines Computerprogramms ermöglicht und für die Testung von Computerprogrammen geeignet ist, die einen Schaltkreis beschreiben. Ferner sollen Verwendungen des Verfahrens angegeben werden.

Diese Aufgabe wird durch die Merkmale des Anspruchs 1 gelöst. Zweckmäßige Ausgestaltungen der Erfindungen ergeben sich aus den Merkmalen der Ansprüche 2 bis 19.

Nach Maßgabe der Erfindung ist ein Verfahren zum Testen eines Computerprogramms nach der Änderung einer ersten Version des Computerprogramms in eine zweite Version des Computerprogramms aufgrund einer Revision des Computerprogramms vorgesehen, umfassend
(a) das Bestimmen der Mutationen, die in die erste Version des Computerprogramms eingebaut werden können oder eingebaut wurden, und der Mutationen, die in die zweite Version des Computerprogramms eingebaut werden können;
(b) das Vergleichen der ersten Version des Computerprogramms mit der zweiten Version des Computerprogramms zum Bestimmen veränderter und unveränderter Mutationen in der zweiten Version gegenüber der ersten Version, wobei

(b1) die Mutationen, die nur in der ersten Version des Computerprogramms oder nur in der zweiten Version des Computerprogramms vorhanden sind, als veränderte Mutationen klassifiziert werden; und

(b2) die Mutationen, die in der ersten und der zweiten Version vorhanden sind, als unveränderte Mutationen klassifiziert werden; und

(c) die Verwendung aller oder eines Teiles der Mutationen, die in Schritt (b) in eine gemeinsame Klasse klassifiziert worden sind, zum Testen und/oder zur Mutationsanalyse der zweiten Version des Computerprogramms.

Eine Mutation ist eine gewollte Veränderung des Computerpro-gramms. Mutationen werden zur Mutationsanalyse in den Quellcode des Computerprogramms eingebaut und anschließend mittels der Mutationsanalyse analysiert. Mutationen können beispielsweise logische Negationsfehler, Auslassen logischer Faktoren, unkorrekte logische Faktoren, Auslassungen von logischen Ausdrücken, unkorrekte logische Ausdrücke, unkorrekte numerische Werte und Fallauslassungen sein.

Mittels der Mutationsanalyse würde überprüft, ob eine in das Computerprogramm eingebaute Mutationen mittels zu mindestens einem Test ("Test case") des zum Testen des Computerprogramms vorgesehen Testsatzes ("Test bench") dedektiert werden kann. Detektieren heißt in diesem Fall der Test zeigt einen Fehler an. Nicht detektierte Mutationen lassen erkennen, ob die Tests eines Testsatzes ausreichend sind, um das Computerprogramm zu testen. Ist eine Mutation mittels der vorhandenen Tests des Testsatzes nicht detektiert, fehlt ein Test in dem Testsatz oder ein oder mehrere Test im Testsatz sind unvollständig. Der Testsatz ist in diesem Fall unvollständig. Die Mutationsanalyse ermöglicht somit eine Überprüfung der Vollständigkeit des Testsatzes, der zum Testen des (unmutierten) Computerprogramms verwendet werden soll.

Unter Regressionstesten wird das erneute Ausführen der Tests eines Testsatzes, die zum Testen der ersten Version des Computerprogramms verwendet werden, zum Testen der zweiten Version des Computerprogramms verstanden. Erfindungsgemäß kann jedoch vorgesehen sein, daß zusätzliche Tests ausgeführt werden, wenn die Mutationsanalyse ergibt, daß der Testsatz, der zum Testen der ersten Version des Computerprogramms verwendet wurde, nicht vollständig ist.

Erfindungsgemäß ist in Schritt (a) vorgesehen, daß die Mutationen, die in erste Version eingebaut werden können, und die Mutationen, die in die zweite Version eingebaut werden können, bestimmt werden. Verfahren zur Bestimmung der Mutationen sind dem Fachmann bekannt. Wesentlich ist, daß dabei für beide Version dieselben, zuvor festgelegten Kriterien zur Auswahl der Mutationen aus einem vorgegebenen Satz von Mutationen angewendet werden. Zur Ausführung des Verfahrens ist es nicht erforderlich, die Mutationen tatsächlich in den Quellcode einzubauen. Es ist hinreichend, die Mutation und die Position, an der sie eingebaut werden kann, zu kennen.

In Schritt (b) ist der Vergleich der beiden Versionen vorgesehen, um veränderte und unveränderte Mutationen zu bestimmen. Dabei wird zweckmäßigerweise der Quellcode beider Version miteinander verglichen, so daß die vorgenommenen Änderungen im Quellcode ermittelt werden können. Anhand dieser Änderungen wird bestimmt, welche Mutationen von den Änderungen betroffen sind (veränderte Mutationen) und welche nicht (unveränderte Mutationen).

In einer ersten Ausführungsform der Erfindung umfaßt das Verfahren in Anschluß an Schritt (b)

(c) die Verwendung aller oder eines Teiles der Mutationen, die in Schritt (b) als veränderte Mutationen klassifiziert worden sind, zum Testen der zweiten Version des Computerprogramms.

In einer zweiten Ausführungsform der Erfindung umfaßt das Verfahren in Anschluß an Schritt (b)

(c) die Verwendung aller oder eines Teiles der Mutationen, die in Schritt (b) als veränderte Mutationen klassifiziert worden sind, zur Mutationsanalyse der zweiten Version des Computerprogramms.

In einer dritten Ausführungsform der Erfindung umfaßt das Verfahren in Anschluß an Schritt (b)

(c) die Verwendung aller oder eines Teiles der Mutationen, die in Schritt (b) als veränderte Mutationen klassifiziert worden sind, zum Regressionstesten der zweiten Version des Computerprogramms.

In einer vierten Ausführungsform der Erfindung umfaßt das Verfahren in Anschluß an Schritt (b)

(c) die Verwendung aller oder eines Teiles der Mutationen, die in Schritt (b) als veränderte Mutationen klassifiziert worden sind, zur Mutationsanalyse oder zum Regressionstesten der zweiten Version des Computerprogramms.

In allen der vorstehend genannten Ausführungsformen können die Ergebnisse einer Mutationenanalyse der ersten Version des Computerprogramms, die mit Mutationen erzielt worden sind, die als unveränderte Mutationen klassifiziert worden sind, ohne weiteres auf die zweite Version übertragen werden, d. h. es wird angenommen, daß die Ergebnisse der unveränderten Mutationen bei einer Mutationenanalyse der zweiten Version des Computerprogramms dieselben Ergebnisse sein würden, die bereits bei der Mutationenanalyse der ersten Version des Computerprogramms erzielt worden sind. Auf diese Weise können beispielsweise die bei der Mutationenanalyse der ersten Version des Computerprogramms gewonnen Ergebnisse, die darin bestehen, welche der unveränderten Mutationen detektiert worden sind und welche nicht, auf die zweite Version übertragen werden, d. h. es wird angenommen, daß die unveränderten Mutationen in gleicher Weise wie bei der ersten Version detektiert werden oder nicht detektiert werden.

Unabhängig von der jeweiligen Ausführungsform kann ferner vorgesehen sein, daß in Schritt (b) als veränderte Mutationen klassifizierte Mutationen, die in der zweiten Version vorhanden sind, nicht aber in der ersten Version, als neue Mutationen klassifiziert werden. Überdies können in Schritt (b) als veränderte Mutationen klassifizierte Mutationen, die in der ersten Version vorhanden sind, nicht aber in der zweiten Version, als entfernte Mutationen klassifiziert werden.

Vorzugsweise wird zum Testen der zweiten Version des Computerprogramms eine Mutationsanalyse der neuen Mutationen durchgeführt. Hat die Mutationsanalyse der neuen Mutationen jedoch ergeben, daß der zum Testen der ersten Version verwendete Testsatz nicht vollständig ist, so wird die zweite Version als nicht vollständig getestet gekennzeichnet oder der Testsatz um solche Tests ergänzt. Anschließend können die Tests des (ergänzten) Testssatzes ausgeführt werden, die die neuen Mutationen detektieren können.

Alternativ oder zusätzlich können zum Testen der zweiten Version des Computerprogramms Tests ausgeführt werden, die bei einer Mutationsanalyse der ersten Version des Computerprogramms die als entfernte Mutationen klassifizierten Mutationen detektierten. Die Ausführung dieser Tests wird im folgenden auch als "verkürzte Regressionstesten" bezeichnet.

Zum Testen der zweiten Version des Computerprogramms in Schritt (c) kann jedoch entweder nur eine Mutationsanalyse der neuen Mutationen mit anschließendem Regressionstesten der zweiten Version des Computerprogramms oder nur das Ausführen von Tests vorgesehen sein, die bei einer Mutationsanalyse der ersten Version des Computerprogramms die als entfernte Mutationen klassifizierten Mutationen detektierten.

In einer bevorzugten Ausführungsform umfaßt das Testen der zweiten Version des Computerprogramms in Schritt (c) die Schritte:

(c1) Ausführen von Tests, die bei einer Mutationsanalyse der ersten Version des Computerprogramms die als entfernte Mutationen klassifizierten Mutationen detektierten, um festzustellen, ob die zweite Version des Computerprogramms dieses Tests besteht; und

(c2) anschließendes Ausführen einer Mutationsanalyse der neuen Mutationen, sofern die zweite Version sämtliche der in Schritt (c1) ausgeführten Tests bestanden hat.

Alternativ kann vorgesehen sein, daß das Testen der zweiten Version des Computerprogramms in Schritt (c) die Schritte umfaßt:

(c1) Ausführen von Tests, die bei einer Mutationsanalyse der ersten Version des Computerprogramms die als entfernte Mutationen klassifizierten Mutationen detektierten, um festzustellen, ob die zweite Version des Computerprogramms diese Tests besteht; und

(c2) anschließendes Ausführen einer Mutationsanalyse der neuen Mutationen.

Ferner kann vorgesehen sein, daß das Testen der zweiten Version des Computerprogramms in Schritt (c) die Schritte umfaßt:
(c1) Ausführen von Tests, die bei einer Mutationsanalyse der ersten Version des Computerprogramms die als entfernte Mutationen klassifizierten Mutationen detektierten, um festzustellen, ob die zweite Version des Computerprogramms diese Tests besteht; und
(c2) anschließendes Ausführen der verbliebenen Tests, die zur Testung der ersten Version des Computerprogramms verwendet wurden.

Vorzugsweise werden die in der ersten Version des Computerprogramms vorhandenen Mutationen in eine erste Liste eingetragen und die in der zweiten Version des Computerprogramms vorhandenen Mutationen in eine zweite Liste eingetragen, wobei die erste Liste und die zweite Liste in Schritt (b) zur Klassifikation der Mutationen miteinander verglichen werden.

Es ist besonders bevorzugt, daß in Schritt (b) die Mutationen als neue Mutationen klassifiziert werden, die entweder
(b11) in Zeilen, Statements und/oder Expressions des Quellcodes der zweiten Version eingebaut werden können, die der zweiten Version des Computerprogramms im Vergleich zur ersten Version des Computerprogramms hinzugefügt worden sind; und/oder
(b12) in Zeilen, Statements und/oder Expressions des Quellcodes der zweiten Version eingebaut werden können, die der zweiten Version des Computerprogramms im Vergleich zur ersten Version des Computerprogramms geändert worden sind.

Ferner können Mutationen als entfernte Mutationen klassifiziert werden, die entweder
(b13) in die Zeilen, Statements und/oder Expressions des Quellcodes der ersten Version eingebaut werden können, die in der zweiten Version des Computerprogramms im Vergleich zur ersten Version des Computerprogramms gelöscht worden sind; und/oder
(b14) in Zeilen, Statements und/oder Expressions des Quellcodes der ersten Version eingebaut werden können, die in der zweiten Version des Computerprogramms im Vergleich zur ersten Version des Computerprogramms verändert worden sind.

Dabei werden bevorzugt alle Mutationen, die nicht als neue Mutationen oder als entfernte Mutationen klassifiziert worden sind, als unbeeinflußte Mutationen klassifiziert.

In einer Ausführungsform der Erfindung wird die zweite Version des Computerprogramms als gegenüber der ersten Version "nicht verschlechtert" bewertet, wenn die Tests bestanden werden, die bei einer Mutationsanalyse der ersten Version des Computerprogramms die als entfernte Mutationen klassifizierten Mutationen detektierten. Ferner kann vorgesehen sein, daß Quellcode, der bei der Mutationsanalyse der als neue Mutationen klassifizierten Mutationen nicht detektierte neue Mutanten enthält, als nicht ausreichend getestet gekennzeichnet wird.

Vorzugsweise beschreibt der Quellcode eine integrierte Schaltung (IC).

Das erfindungsgemäße Verfahren kann unter Verwendung eines Field Programmable Gate Array (FPGA) durchgeführt werden.

Das erfindungsgemäße Verfahren ermöglicht das schnelle Auffinden fehlerhafter Veränderung eines Computerprogramms. Dies ist insbesondere darauf zurückzuführen, daß selektiv Mutationen zum Testen verwendet werden, die durch Klassifikation der Mutationen, die sich in den verglichenen Versionen des Computerprogramms finden, bestimmt werden. Die vorgeschlagene Klassifikation ermöglicht es ferner, früher als bisher Fehler, die auf Änderungen des Codes zurückzuführen sind, zu erkennen, da zuerst die Tests ausgeführt werden, die entfernte Mutationen detektieren würden ("verkürztes Regressionstesten"). Sind in der ersten Version die Tests bestanden worden und treten beim Ausführen der Tests in der zweiten Version nun Fehler auf, so hat die Änderung des Quellcodes von der ersten zur zweiten Version zu diesem Fehler geführt. Die zweite Version ist somit fehlerhaft. Anschließend können die als neu klassifizierten Mutationen einer Mutationsanalyse unterzogen werden. Alternativ kann zunächst eine Mutationsanalyse der neuen Mutationen durchgeführt werden und dann Tests, die die als entfernte Mutationen klassifizierten Mutationen beim Testen der ersten Version des Computerprogramms detektierten, ausgeführt.

Das erfindungsgemäße Verfahren kann vorteilhaft zum Regressionstesten von Computerprogrammen und/oder zur Mutationsanalyse von Computerprögrammen verwendet werden.

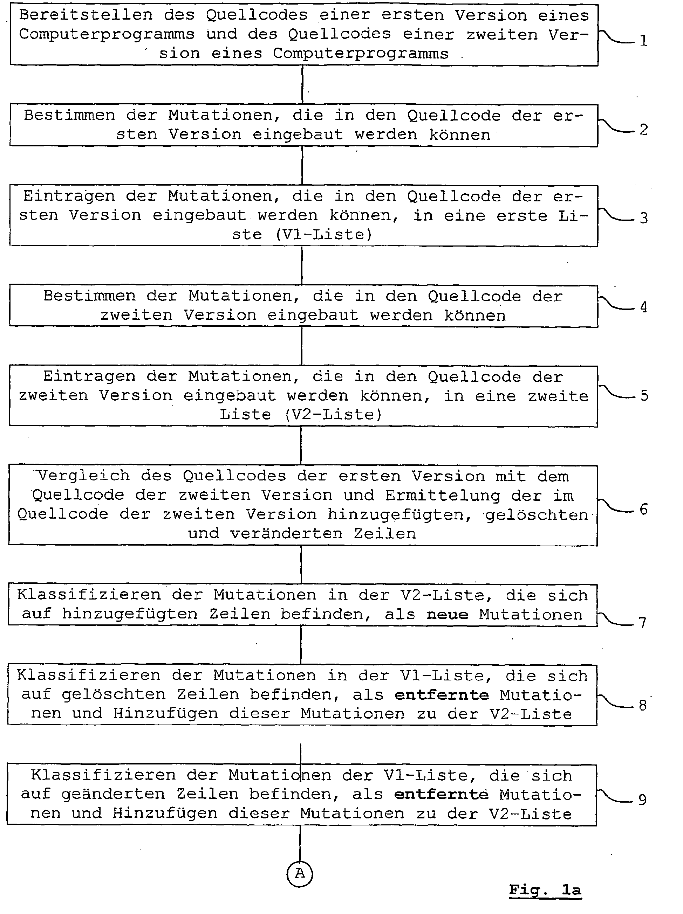

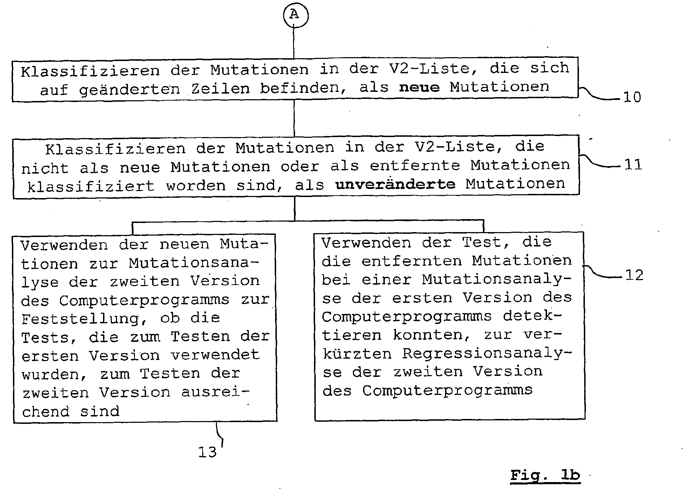

Die Erfindung wird anschließend unter Bezugnahme auf die Zeichnungen anhand eines Beispiels näher erläutert. Dabei zeigt
- Fig. 1a und b: ein Ablaufdiagramm einer Ausführungsform des erfindungsgemäßen Verfahrens.

In der nachfolgend beschriebenen Ausführungsform des erfindungsgemäßen Verfahrens wird die erste Version des Computerprogramms mit der zweiten Version des Computerprogramms verglichen (siehe Bezugszeichen 1 in Fig. 1a). Dies kann unter Verwendung eines File Comparison Tools, das auch als diff tool bekannt ist, oder mittels einer Syntaxbaumanalyse geschehen.

Nachstehend ist der Quellcode einer ersten Version eines Computerprogramms dargestellt:

```
1    always @(posedge clk or negedge reset_n) begin
2      if(∼reset_n ) begin
3        q_r <= 1'b0;
4      end
5      else begin
6        q_r <= d & enable;
7        q_n_r <= d & enable;
8      end
9      enable <= 1'b0;
10    end
```

Nach der Revision des Computerprogramms wird die zweite Version erhalten:

```
1     always @(posedge clk or negedge reset_n) begin
2     if(∼reset_n ) begin
3        q_r <= 1'b0;
4        q_n_r <= 1'b1;
5        end
6        else begin
7           q_r <= d & enable;
8           q_n_r <= ∼d & enable;
9        end
10     end
```

Zur Klassifikation der Mutanten als neue Mutanten, entfernte Mutanten und veränderte Mutanten werden die beiden Versionen des Computerprogramms miteinander verglichen. Dazu werden zunächst die Mutationen bestimmt, die in die erste Version eingebaut werden können (Bezugszeichen 2 in Fig. 1a). Diese Mutationen, d. h. deren Positionen ("Zeile") im Quellcode der ersten Version, werden in einer ersten Liste gespeichert, die nachfolgend als "Vl-Liste" bezeichnet wird (Bezugszeichen 3 in Fig. 1). Dabei wird jeder Mutation eine Identifizierungsnummer (ID-Nr.) zugeordnet. Ferner wird der Typ der Mutante in der V1-Liste gespeichert.

V1-Liste:

| ID-Nr. | Zeile | Typ |
|---|---|---|
| 1 | 2 | if |
| 2 | 3 | <= |
| 3 | 3 | constant 0 |
| 4 | 6 | <= |
| 5 | 6 | operator & |
| 6 | 7 | <= |
| 7 | 7 | operator & |
| 8 | 9 | <= |
| 9 | 9 | constant 0 |

Anschließend werden die Mutationen bestimmt, die in der zweiten Version des Computerprogramms eingebaut werden können (Bezugszeichen 4 in Fig. 1a). Diese Mutationen d. h. deren Positionen im Quellcode der ersten Version, werden in einer Liste gespeichert, die nachfolgend als "V2-Liste" bezeichnet wird (Bezugszeichen 5 in Fig. 1a). Dabei wird jeder Mutation eine Identifizierungsnummer ("ID-Nr.") zugeordnet. Ferner wird der Typ der Mutante in der V2-Liste gespeichert.

V2-Liste

| ID-Nr. | Zeile | Typ |
|---|---|---|
| 1 | 2 | if |
| 2 | 3 | <= |
| 3 | 3 | constant 0 |
| 4 | 4 | <= |
| 5 | 4 | constant 1 |
| 6 | 7 | <= |
| 7 | 7 | operator & |
| 8 | 8 | <= |
| 9 | 8 | operator & |
| 10 | 8 | operator ∼ |

Der Vergleich (Bezugszeichen 6 in Fig. 1a) des Quellcodes der ersten Version des Computerprogramms mit dem Quellcode der zweiten Version des Computerprogramms unter Verwendung des Diff-Tools führt zu folgendem Ergebnis:

| Spalte 1 | Spalte 2 |
|---|---|
| 3a4 | |
| > | q_n_r <= 1'b1; |
| 7c8 | |
| < | q_n_r <= d & enable; |
| --- | |
| > | q_n_r <= ∼d & enable; |
| 9d9 | |
| < | enable <= 1'b0; |

Die in Spalte 1 dargestellten Ausdrücke sind in der Form "XyZ", wobei X die Zeile im Quellcode der ersten Version des Computerprogramms bezeichnet; y wiedergibt, ob die Zeile in der zweiten Version hinzugefügt worden ist (mit "a" gekennzeichnet), ob die Zeile in der zweiten Version verändert worden ist (mit "c" gekennzeichnet) oder ob die Zeile in der zweiten Version gelöscht worden ist (mit "d" gekennzeichnet); und Z die Zeile im Quellcode der zweiten Version des Computerprogramms bezeichnet. Spalte 2 gibt die Art der Veränderung wieder.

Das Ergebnis des Vergleiches mittels des Diff-Tools wird verwendet, um die Mutationen zu klassifizieren.

Alle Mutanten in der V2-Liste, die sich auf hinzugefügten Linien(mit "a" gekennzeichnet) befinden, werden als neue Mutationen ("neu") klassifiziert (Bezugszeichen 7 in Fig. 1a):

**V2-Liste**

| ID-Nr. | Zeile | Typ | klassifiziert als |
|---|---|---|---|
| 1 | 2 | if | |
| 2 | 3 | <= | |
| 3 | 3 | constant 0 | |
| 4 | 4 | <= | neu |
| 5 | 4 | constant 1 | neu |
| 6 | 7 | <= | |
| 7 | 7 | oparator & | |
| 8 | 8 | <= | |
| 9 | 8 | operator & | |
| 10 | 8 | operator ∼ | |

Anschließend werden alle Mutationen, die in der V1-Liste vorhanden sind und sich auf gelöschten Zeilen (mit entfernt gekennzeichnet) befinden, zu der V2-Liste hinzugefügt und als entfernte Mutationen ("entfernt") klassifiziert (Bezugszeichen 8 in Fig. 1a):

**V2-Liste**

| ID-Nr. | Zeile | Typ | klassifiziert als |
|---|---|---|---|
| 1 | 2 | if | |
| 2 | 3 | <= | |
| 3 | 3 | constant 0 | |
| 4 | 4 | <= | neu |
| 5 | 4 | constant 1 | neu |
| 6 | 7 | <= | |
| 7 | 7 | operator & | |
| 8 | 8 | <= | |
| 9 | 8 | operator & | |
| 10 | 8 | operator ∼ | |
| 11 | 9 | <= | entfernt |
| 12 | 9 | constant 0 | entfernt |

Dann werden alle Mutationen, die in der V1-Liste vorhanden sind und sich auf geänderten Zeilen befinden, zu der V2-Liste hinzugefügt und als entfernte Mutationen ("entfernt") klassifiziert (Bezugszeichen 9 in Fig. 1a):

**V2-Liste**

| ID-Nr. | Zeile | Typ | klassifiziert als |
|---|---|---|---|
| 1 | 2 | if | |
| 2 | 3 | <= | |
| 3 | 3 | constant 0 | |
| 4 | 4 | <= | neu |
| 5 | 4 | constant 1 | neu |
| 6 | 7 | <= | |
| 7 | 7 | operator & | |
| 8 | 8 | <= | |
| 9 | 8 | operator & | |
| 10 | 8 | operator ∼ | |
| 11 | 9 | <= | entfernt |
| 12 | 9 | constant 0 | entfernt |
| 13 | 7 | <= | entfernt |
| 14 | 7 | operator & | entfernt |

Dann werden alle Mutationen, die in der V2-Liste vorhanden sind und sich auf geänderten Zeilen befinden, als neue Mutationen klassifiziert (Bezugszeichen 10 in Fig. 1b):

**V2-Listel**

| ID-Nr. | Zeile | Typ | klassifiziert als |
|---|---|---|---|
| 1 | 2 | if | |
| 2 | 3 | <= | |
| 3 | 3 | constant 0 | |
| 4 | 4 | <= | neu |
| 5 | 4 | constant 1 | neu |
| 6 | 7 | <= | |
| 7 | 7 | operator & | |
| 8 | 8 | <= | neu |
| 9 | 8 | operator & | neu |
| 10 | 8 | operator ∼ | neu |
| 11 | 9 | <= | entfernt |
| 12 | 9 | constant 0 | entfernt |
| 13 | 7 | <= | entfernt |
| 14 | 7 | operator & | entfernt |

Schließlich werden alle Mutationen in der V2-Liste, die nicht als neue oder entfernte Mutationen klassifiziert worden sind, als unveränderte Mutationen ("unverändert") klassifiziert (Bezugszeichen 11 in Fig. 1b):

**V2-Liste**

| ID-Nr. | Zeile | Typ | klassifiziert als |
|---|---|---|---|
| 1 | 2 | if | unverändert |
| 2 | 3 | <= | unverändert |
| 3 | 3 | constant 0 | unverändert |
| 4 | 4 | <= | neu |
| 5 | 4 | constant 1 | neu |
| 6 | 7 | <= | unverändert |
| 7 | 7 | operator & | unverändert |
| 8 | 8 | <= | neu |
| 9 | 8 | operator & | neu |
| 10 | 8 | operator ∼ | neu |
| 11 | 9 | <= | entfernt |
| 12 | 9 | constant 0 | entfernt |
| 13 | 7 | <= | entfernt |
| 14 | 7 | operator & | entfernt |

In einer Ausführungsform (Bezugszeichen 12 in Fig. 1b) werden zuerst oder ausschließlich die auf V2-Liste als entfernte Mutationen klassifizierten Mutanten zum verkürzten Regressionstesten der zweiten Version des Computerprogramms verwendet. Dabei wird die zweite Version des Computerprogramms als gegenüber der ersten Version "nicht verschlechtert" bewertet, wenn die Tests bestanden werden, die bei einer Mutationsanalyse der ersten Version des Computerprogramms die als entfernte Mutationen klassifizierten Mutationen detektierten.

In einer anderen Ausführungsform (Bezugszeichen 13 in Fig. 1b) der Erfindung werden zuerst oder ausschließlich die auf der V2-Liste als neue Mutationen klassifizierten Mutanten zur Mutationsanalyse der zweiten Version des Computerprogramms verwendet. Quellcode, der bei der Mutationsanalyse der als neue Mutationen klassifizierten Mutationen nicht detektierte neue Mutanten enthält, wird für den Tester als nicht ausreichend getestet gekennzeichnet.

Die Erfindung ermöglicht somit durch die Klassifikation der Mutationen und die Nutzung zuerst oder ausschließlich entweder der als neu oder der als entfernt klassifizierten Mutationen für das Testen der zweiten Version des Computerprogramms eine erhebliche Zeitersparnis gegenüber bekannten Verfahren durch das schnelle Auffinden fehlerhafter Veränderungen, da die Klassifikation und anschließende Selektion bestimmter Mutationen, eine Ausführen nur der Tests erlaubt, die diese Mutationen detektieren können.

Werden beispielsweise zuerst (oder ausschließlich) Tests ausgeführt, die Mutationen detektieren können, die in der ersten Version detektiert worden und als entfernte Mutationen klassifiziert worden sind, so kann in einem sehr frühem Teststadium erkannt werden, ob in der ersten Version vorhandene Feature des Computerprogramms, die durch dessen Revision nicht beeinflußt werden sollen, beeinträchtigt worden sind. Entfernte Mutationen stellen eine Featureänderung dar. Im Hinblick auf das Ziel der Regressionsanalyse sicherzustellen, daß alle Quellcodeänderungen getestet werden, wird durch die Auswahl nur der Tests, die entfernte Mutationen detektieren, eine minimale Menge ("Subset") von Tests ausgewählt, von den aus der Analyse der ersten Version bekannt ist, daß sie mögliche Probleme detektieren können, die eng mit den vorgenommenen Änderungen verbunden sind. Die ausgewählten Tests müssen bestanden werden, um zu bestätigen, daß der Quellcode der zweiten Version noch korrekt ist. Dies führt zu einer schnellen Feststellung, ob vorgenommene Veränderungen fehlerhaft sind.

Wird hingegen zuerst (oder ausschließlich) eine Mutationsanalyse ausgeführt, um festzustellen, welche der als neue Mutationen klassifizierte Mutationen durch Tests des zum Testen der ersten Version des Computerprogramms verwendeten Testsatzes detektiert werden können, so zeigen nicht detektierte Mutanten, daß das Testset nicht vollständig ist, d. h. keine Tests umfaßt, die zumindest eine bestimmte neue Mutation detektieren können. Auf diese Weise kann festgestellt werden, ob die neuen Features tatsächlich durch den verwendeten Testsatz getestet werden.

Vorzugsweise werden zunächst Tests ausgeführt, die Mutationen detektieren können, die in der ersten Version detektiert worden und als entfernte Mutationen klassifiziert worden sind.

Anschließend wird eine Mutationsanalyse der neuen Mutationen durchgeführt.

## Patentansprüche

1. Verfahren zum Testen eines Computerprogramms nach der Änderung einer ersten Version des Computerprogramms in eine zweite Version des Computerprogramms aufgrund einer Revision des Computerprogramms (1), umfassend
(a) das Bestimmen der Mutationen, die in die erste Version des Computerprogramms eingebaut werden können (2), und der Mutationen, die in die zweite Version des Computerprogramms eingebaut werden können (4);
(b) das Vergleichen der ersten Version des Computerprogramms mit der zweiten Version des Computerprogramms zum Bestimmen veränderter und unveränderter Mutationen in der zweiten Version gegenüber der ersten Version (6), wobei
(b1) die Mutationen, die nur in die erste Version des Computerprogramms oder nur in die zweite Version des Computerprogramms eingebaut werden können, als veränderte Mutationen klassifiziert werden (7, 8, 9, 10); und
(b2) die Mutationen, die in die erste und in die zweite Version eingebaut werden können, als unveränderte Mutationen klassifiziert werden (11); und
(c) die Verwendung aller oder eines Teiles der Mutationen, die in Schritt (b) in eine gemeinsame Klasse klassifiziert worden sind, zum Testen und/oder zur Mutationsanalyse der zweiten Version des Computerprogramms (12, 13).

2. Verfahren nach Anspruch 1, umfassend ferner
(c) die Verwendung aller oder eines Teiles der Mutationen, die in Schritt (b) als veränderte Mutationen klassifiziert worden sind, zum Testen der zweiten Version des Computerprogramms.

3. Verfahren nach Anspruch 1 oder Anspruch 2, umfassend ferner
(c) die Verwendung aller oder eines Teiles der Mutationen, die in Schritt (b) als veränderte Mutationen klassifiziert worden sind, zur Mutationsanalyse der zweiten Version des Computerprogramms.

4. Verfahren nach Anspruch 1 oder Anspruch 2, umfassend ferner
(c) die Verwendung der Ergebnisse einer Mutationsanalyse aller oder eines Teiles der Mutationen, die in die erste Version des Computerprogramms eingebaut werden können und die in Schritt (b) als veränderte Mutationen klassifiziert worden sind, zur Auswahl von Tests zum verkürzten Regressionstesten der zweiten Version des Computerprogramms (12).

5. verfahren nach einem der vorstehenden Ansprüche, umfassend ferner
(c) die Verwendung der Ergebnisse einer Mutationsanalyse aller oder eines Teiles der Mutationen, die in die erste Version des Computerprogramms eingebaut werden können und die in Schritt (b) als veränderte Mutationen klassifiziert worden sind, zur Auswahl von Tests zum verkürzten Regressionstesten der zweiten Version des Computerprogramms; und die Verwendung aller oder eines Teiles der Mutationen, die in Schritt (b) als veränderte Mutationen klassifiziert worden sind, mit Ausnahme derjenigen, die in die erste Version des Computerprogramms eingebaut werden können, zur Mutationsanalyse der zweiten Version des Computerprogramms.

6. Verfahren nach einem der vorstehenden Ansprüche, **dadurch gekennzeichnet, daß** in Schritt (b) als veränderte Mutationen klassifizierte Mutationen, die in die zweite Version eingebaut werden können, nicht aber in die erste Version, als neue Mutationen klassifiziert werden (7).

7. Verfahren nach einem der vorstehenden Ansprüche, **dadurch gekennzeichnet, daß** in Schritt (b) als veränderte Mutationen klassifizierte Mutationen, die in die erste Version eingebaut werden können, nicht aber in die zweite Version, als entfernte Mutationen klassifiziert werden (8, 9).

8. Verfahren nach einem der vorstehenden Ansprüche, **dadurch gekennzeichnet, daß** zum Testen der zweiten Version des Computerprogramms eine Mutationsanalyse der neuen Mutationen durchgeführt wird (13).

9. Verfahren nach einem der vorstehenden Ansprüche, **dadurch gekennzeichnet, daß** zum Testen der zweiten Version des Computerprogramms Tests ausgeführt werden, die bei einer Mutationsanalyse der ersten Version des Computerprogramms die als entfernte Mutationen klassifizierten Mutationen detektierten.

10. Verfahren nach einem Ansprüche 2 bis 9, **dadurch gekennzeichnet, daß** zum Testen der zweiten Version des Computerprogramms in Schritt (c) nur eine Mutationsanalyse der neuen Mutationen durchgeführt wird.

11. Verfahren nach einem der Ansprüche 2 bis 9, **dadurch gekennzeichnet, daß** zum Testen der zweiten Version des Computerprogramms nur Tests ausgeführt werden, die bei einer Mutationsanalyse der ersten Version des Computerprogramms die als entfernte Mutationen klassifizierten Mutationen detektierten.

12. Verfahren nach einem der Ansprüche 2 bis 9, **dadurch gekennzeichnet, daß** das Testen der zweiten Version des Computerprogramms in Schritt (c) die Schritte umfaßt:
(c1) Ausführen von Tests, die bei einer Mutationsanalyse der ersten Version des Computerprogramms die als entfernte Mutationen klassifizierten Mutationen detektierten, um festzustellen, ob die zweite Version des Computerprogramms diese Tests besteht; und
(c2) anschließendes Ausführen einer Mutationsanalyse der neuen Mutationen, sofern die zweite Version sämtliche der in Schritt (c1) ausgeführten Tests bestanden hat.

13. Verfahren nach einem der Ansprüche 2 bis 9, **dadurch gekennzeichnet, daß** das Testen der zweiten Version des Computerprogramms in Schritt (c) die Schritte umfaßt:
(c1) Ausführen von Tests, die bei einer Mutationsanalyse der ersten Version des Computerprogramms die als entfernte Mutationen klassifizierten Mutationen detektierten, um festzustellen, ob die zweite Version des Computerprogramms diese Tests besteht; und
(c2) anschließendes Ausführen einer Mutationsanalyse der neuen Mutationen.

14. Verfahren nach einem der Ansprüche 2 bis 9, **dadurch gekennzeichnet, daß** das Testen der zweiten Version des Computerprogramms in Schritt (c) die Schritte umfaßt:
(c1) Ausführen von Tests, die bei einer Mutationsanalyse der ersten Version des Computerprogramms die als entfernte Mutationen klassifizierten Mutationen detektierten, um festzustellen, ob die zweite Version des Computerprogramms diese Tests besteht; und
(c2) anschließendes Ausführen der verbliebenen Test, die zur Testung der ersten Version des Computerprogramms verwendet wurden, sofern die zweite Version sämtliche in Schritt (c1) ausgeführten Tests bestanden hat.

15. Verfahren nach einem der vorstehenden Ansprüche, **dadurch gekennzeichnet, daß** die Mutationen als neue Mutationen klassifiziert werden, die entweder
(b11) in Zeilen, Statements und/oder Expressions des Quellcodes der zweiten Version eingebaut werden können, die der zweiten Version des Computerprogramms im Vergleich zur ersten Version des Computerprogramms hinzugefügt worden sind; und/oder
(b12) in Zeilen, Statements und/oder Expressions des Quellcodes der zweiten Version eingebaut werden können, die in der zweiten Version des Computerprogramms im Vergleich zur ersten Version des Computerprogramms geändert worden sind.

16. Verfahren nach einem der vorstehenden Ansprüche, **dadurch gekennzeichnet, daß** die Mutationen als entfernte Mutationen klassifiziert werden, die entweder
(b13) in Zeilen, Statements und/oder Expressions des Quellcodes der ersten Version eingebaut werden können, die in der zweiten Version des Computerprogramms im Vergleich zur ersten Version des Computerprogramms gelöscht worden sind; und/oder
(b14) in Zeilen, Statements und/oder Expressions des Quellcodes der ersten Version eingebaut werden können, die in der zweiten Version des Computerprogramms im Vergleich zur ersten Version des Computerprogramms verändert worden sind.

17. Verfahren nach einem der vorstehenden Ansprüche, **dadurch gekennzeichnet, daß** alle Mutationen, die in Zeilen, Statements und/oder Expressions des Quellcodes der zweiten Version eingebaut werden können und die nicht als neue Mutationen oder als entfernte Mutationen klassifiziert worden sind, als unveränderte Mutationen klassifiziert werden.

18. Verfahren nach einem vorstehenden Ansprüche, **dadurch gekennzeichnet, daß** die zweite Version des Computerprogramms als gegenüber der ersten Version "nicht verschlechtert" bewertet wird, wenn die Tests bestanden werden, die bei einer Mutationsanalyse der ersten Version des Computerprogramms die als entfernte Mutationen klassifizierten Mutationen detektierten.

19. Verfahren nach einem der vorstehenden Ansprüche, **dadurch gekennzeichnet, daß** Quellcode, der bei der Mutationsanalyse der als neue Mutationen klassifizierten Mutationen nicht detektierte neue Mutanten enthält, als nicht ausreichend getestet **gekennzeichnet** wird.

## Claims

1. Method for testing a computer program after changing a first version of the computer program into a second version of the computer program due to a revision of the computer program (1), comprising
(a) determining the mutations that can be or have been inserted into the first version of the computer program (2), and the mutations that can be inserted into the second version of the computer program (4) ;
(b) comparing the first version of the computer program with the second version of the computer program to determine changed and unchanged mutations in the second version against the first version (6), wherein
(b1) the mutations that can be inserted only in the first version of the computer program or only in the second version of the computer program are classified as changed mutations (7, 8, 9, 10); and
(b2) the mutations that can be inserted in the first and the second version are classified as unchanged mutations (11); and
(c) using all or a part of the mutations that have been classified into a common class in step (b) for testing and/or mutation analysis the second version of the computer program (12, 13).

2. Method according to claim 1, further comprising
(c) the use of all or a part of the mutations which in step (b) have been classified as changed mutations for testing the second version of the computer program.

3. Method according to claim 1 or claim 2, further comprising
(c) the use of all or a part of the mutations which in step (b) have been classified as changed mutations for the mutation analysis of the second version of the computer program.

4. Method according to claim 1 or claim 2, further comprising
(c) the use of the results of a mutation analysis of all or a part of the mutations which can be inserted into the first version of the computer program and which in step (b) have been classified as changed mutations to select tests for the reduced regression testing of the second version of the computer program (12).

5. Method according to any one of the preceding claims, further comprising
c) the use of the results of a mutation analysis of all or a part of the mutations which can be inserted into the first version of the computer program and which in step (b) have been classified as changed mutations to select tests for the reduced regression testing of the second version of the computer program; and the use of all or a part of the mutations classified in step (b) as changed mutations except for that which can be inserted into the first version of the computer program for the mutation analysis of the second version of the computer program.

6. Method according to any one of the preceding claims, **characterized in that** in step (b) mutations classified as changed mutations that can be inserted into the second version but not into the first version are classified as new mutations (7).

7. Method according to any one of the preceding claims, **characterized in that** in step (b) mutations classified as changed mutations that can be inserted into the first version but not into the second version are classified as removed mutations (8, 9).

8. Method according to any one of the preceding claims, **characterized in that** for testing the second version of the computer program a mutation analysis of the new mutations is conducted (13).

9. Method according to any one of the preceding claims, **characterized in that** for testing the second version of the computer program tests are performed that upon a mutation analysis of the first version of the computer program detected mutations classified as removed mutations.

10. Method according to any one of claims 2 to 9, **characterized in that** for testing the second version of the computer program in step (c) only one mutation analysis of the new mutations is conducted.

11. Method according to any one of claims 2 to 9, **characterized in that** for testing the second version of the computer program only tests are performed that upon a mutation analysis of the first version of the computer program detected mutations classified as removed mutations.

12. Method according to any one of claims 2 to 9, **characterized in that** testing the second version of the computer program in step (c) comprises the steps of:
(c1) performing tests that upon a mutation analysis of the first version of the computer program detected the mutations classified as removed mutations to ascertain whether the second version of the computer program passes these tests; and
(c2) subsequently performing a mutation analysis of the new mutations provided that the second version has passed all test carried out in step (c1).

13. Method according to any one of claims 2 to 9, **characterized in that** testing the second version of the computer program in step (c) comprises the steps of:
(c1) performing tests that upon a mutation analysis of the first version of the computer program detected the mutations classified as removed mutations to ascertain whether the second version of the computer program passes these tests; and
(c2) subsequently performing a mutation analysis of the new mutations.

14. Method according to any one of claims 2 to 9, **characterized in that** testing the second version of the computer program in step (c) comprises the steps of:
(c1) performing tests that upon a mutation analysis of the first version of the computer program detected the mutations classified as removed mutations to ascertain whether the second version of the computer program passes these tests; and
(c2) subsequently performing the remaining tests used for the test of the first version of the computer program provided that the second version has passed all the tests performed in step (c1).

15. Method according to any one of the preceding claims, **characterized in that** the mutations are classified as new mutations that either
(b11) can be inserted into lines, statements and/or expressions of the source code of the second version which have been added to the second version of the computer program compared to the first version of the computer program; and/or
(b12) can be inserted into lines, statements and/or expressions of the source code of the second version which have been changed in the second version of the computer program compared to the first version of the computer program.

16. Method according to any one of the preceding claims, **characterized in that** mutations are classified as removed mutations that either
(b13) can be inserted into lines, statements and/or expressions of the source code of the first version which have been deleted in the second version of the computer program compared to the first version of the computer program; and/or
(b14) can be inserted into lines, statements and/or expressions of the source code of the first version which have been changed in the second version of the computer program compared to the first version of the computer program.

17. Method according to any one of the preceding claims, **characterized in that** all mutations that can be inserted into lines, statements and/or expressions of the source code of the second version and have not been classified as new mutations or as removed mutations are classified as unchanged mutations.

18. Method according to any one of the preceding claims, **characterized in that** the second version of the computer program is assessed as "not deteriorated" against the first version if the tests are passed that upon a mutation analysis of the first version of the computer program detected mutations classified as removed mutations.

19. Method according to any one of the preceding claims, **characterized in that** source code containing not detected new mutants classified upon the mutation analysis of the mutations as new mutations, is **characterized** as not sufficiently tested.

## Revendications

1. Procédure pour tester un programme informatique après la modification d'une première version en une deuxième version du programme informatique en raison de la révision du programme informatique (1), comprenant
(a) la détermination des mutations pouvant être installées dans la première version du programme informatique (2) et des mutations pouvant être installées dans la deuxième version du programme informatique (4);
(b) la comparaison de la première version du programme informatique avec la deuxième version du programme informatique afin de déterminer les mutations modifiées ou non modifiées dans la deuxième version par rapport à la première version (6),
(b1) les mutations qui peuvent être installées uniquement dans la première version du programme informatique ou uniquement dans la deuxième version du programme informatique étant classées comme mutations modifiées (7, 8, 9, 10); et
(b2) les mutations qui peuvent être installées dans la première et la deuxième versions étant classées comme mutations non modifiées (11);
(c) l'application de toutes ou d'une partie des mutations classées à la démarche (b) en une classe commune pour tester et/ou analyser les mutations de la deuxième version du programme informatique (12, 13).

2. Procédure selon la revendication 1, comprenant de plus
(c) l'utilisation de toutes ou d'une partie des mutations classées à la démarche (b) comme mutations modifiées pour tester la deuxième version du programme informatique.

3. Procédure selon la revendication 1 ou revendication 2, comprenant de plus
(c) l'utilisation de toutes ou d'une partie des mutations classées à la démarche (b) comme mutations modifiées pour analyse de mutation de la deuxième version du programme informatique.

4. Procédure selon la revendication 1 ou revendication 2, comprenant de plus
(c) l'utilisation des résultats d'une analyse de mutations de toutes ou d'une partie des mutations pouvant être installées dans la première version du programme informatique et classées à la démarche (b) comme mutations modifiées, pour sélectionner les tests pour tests raccourcis de régression de la deuxième version du programme informatique (12).

5. Procédure selon l'une des revendications précédentes comprenant de plus
(c) l'utilisation des résultats d'une analyse de mutations de toutes ou d'une partie des mutations pouvant être installées dans la première version du programme informatique et classées à la démarche (b) comme mutations modifiées, pour sélectionner les tests pour tests raccourcis de régression de la deuxième version du programme informatique; et l'utilisation des résultats de toutes ou d'une partie des mutations classées à la démarche (b) comme mutations modifiées à l'exception de celles qui peuvent être installées dans la première version du programme informatique, pour analyse de mutations de la deuxième version du programme informatique.

6. Procédure selon l'une des revendications précédentes **caractérisée en ce que** des mutations classées à la démarche (b) comme mutations modifiées qui peuvent être installées dans la deuxième version mais par dans la première version sont classées comme nouvelles mutations (7).

7. Procédure selon l'une des revendications précédentes **caractérisée en ce que** des mutations classées à la démarche (b) comme mutations modifiées qui peuvent être installées dans la première version mais par dans la deuxième version sont classées comme mutations supprimées (8, 9).

8. Procédure selon l'une des revendications précédentes **caractérisée en ce que** pour tester la deuxième version du programme informatique, il est réalisé une analyse de mutation des nouvelles mutations (13).

9. Procédure selon l'une des revendications précédentes **caractérisée en ce que** pour tester la deuxième version du programme informatique, il est exécuté des tests qui détectent les mutations classées comme mutations supprimées lors d'une analyse de mutation de la première version du programme informatique.

10. Procédure selon l'une des revendications 2 à 9 **caractérisée en ce que** pour tester la deuxième version du programme informatique à la démarche (c), il n'est réalisé qu'une analyse des nouvelles mutations.

11. Procédure selon l'une des revendications 2 à 9 **caractérisée en ce que** pour tester la deuxième version du programme informatique, il n'est exécuté que des tests qui détectent les mutations classées comme mutations supprimées lors d'une analyse de mutation de la première version du programme informatique.

12. Procédure selon l'une des revendications 2 à 9 **caractérisée en ce que** le test de la deuxième version du programme informatique à la démarche (c) comprend les opérations:
(c1) exécution de tests qui détectent les mutations classées comme mutations supprimées lors d'une analyse de mutations de la première version du programme informatique pour constater si la deuxième version du programme informatique a réussi ces tests; et
(c2) exécution par la suite d'une analyse de mutations des nouvelles mutations dans la mesure où la deuxième version a réussi l'ensemble des tests exécutés à la démarche (c1).

13. Procédure selon l'une des revendications 2 à 9 **caractérisée en ce que** le test de la deuxième version du programme informatique à la démarche (c) comprend les opérations:
(c1) exécution de tests qui détectent les mutations classées comme mutations supprimées lors d'une analyse de mutations de la première version du programme informatique pour constater si la deuxième version du programme informatique a réussi ces tests; et
(c2) exécution par la suite d'une analyse de mutations des nouvelles mutations.

14. Procédure selon l'une des revendications 2 à 9 **caractérisée en ce que** le test de la deuxième version du programme informatique à la démarche (c) comprend les opérations:
(c1) exécution de tests qui détectent les mutations classées comme mutations supprimées lors d'une analyse de mutations de la première version du programme informatique pour constater si la deuxième version du programme informatique a réussi ces tests; et
(c2) exécution par la suite des tests restants qui ont été utilisés pour tester la première version du programme informatique dans la mesure où la deuxième version a réussi l'ensemble des tests exécutés à la démarche (c1).

15. Procédure selon l'une des revendications précédentes **caractérisée en ce que** les mutations sont classées comme nouvelles mutations qui
(b11)peuvent être intégrées soit dans des lignes, statements et/ou expressions du code-source de la deuxième version qui ont été ajoutés à la deuxième version du programme informatique par rapport à la première version du programme informatique; et/ou
(b12)peuvent être intégrées soit dans des lignes, statements et/ou expressions du code-source de la deuxième version qui ont été modifiés dans la deuxième version du programme informatique par rapport à la première version du programme informatique.

16. Procédure selon l'une des revendications précédentes **caractérisée en ce que** les mutations sont classées comme mutations supprimées qui
(b13)peuvent être intégrées soit dans des lignes, statements et/ou expressions du code-source de la première version qui ont été supprimés dans la deuxième version du programme informatique par rapport à la première version du programme informatique; et/ou
(b14)peuvent être intégrées soit dans des lignes, statements et/ou expressions du code-source de la première version qui ont été modifiés dans la deuxième version du programme informatique par rapport à la première version du programme informatique.

17. Procédure selon l'une des revendications précédentes **caractérisée en ce que** toutes les mutations pouvant être intégrées dans des lignes, des statements et/ou des expressions du code-source de la deuxième version et qui n'ont pas été classés comme nouvelles mutations ou comme mutations supprimées, sont classées comme mutations inchangées.

18. Procédure selon l'une des revendications précédentes **caractérisée en ce que** la deuxième version du programme informatique est évaluée "non plus mauvaise" par rapport à la première version si elle a réussi les tests qui ont détecté les mutations classées comme mutations supprimées lors d'une analyse de mutation de la première version du programme informatique.

19. Procédure selon l'une des revendications précédentes **caractérisée en ce que** le code-source contenant de nouveaux mutants non détectés lors de l'analyse de mutation des mutations classées comme nouvelles mutations est **caractérisé** comme non suffisamment testé.
